# EUROPÄISCHE PATENTSCHRIFT

(11) **EP 0 945 714 B1**
(45) Veröffentlichungstag und Bekanntmachung des Hinweises auf die Patenterteilung: **20.10.2010**
(21) Anmeldenummer: 98104762.4
(22) Anmeldetag: 17.03.1998
(51) Int. Cl.: G01F 23/284, H05K 5/06

(54) **Elektronisches Gerät für den Einsatz in explosionsgefährdeten Bereichen**
Electronic device used in potentially explosive environment
Dispositif électronique utilisé dans un environnement susceptible d'explosion

(43) Veröffentlichungstag der Anmeldung: 29.09.1999
(73) Patentinhaber: Endress+Hauser (Deutschland) AG+Co. KG, 79576 Weil am Rhein (DE); Endress+Hauser GmbH+Co. KG, 79689 Maulburg (DE)
(72) Erfinder: Maier, Winfried, 79689 Maulburg (DE); Güthner, Hartmut, 79576 Weil am Rhein (DE); Cudini, Roberto, 4055 Basel (CH)

(56) Entgegenhaltungen:
- WO-A-91/05226
- WO-A-97/12206
- WO-A-98/14763
- DE-A- 2 946 281
- DE-A- 3 711 754
- DE-A- 19 532 646
- DE-B- 1 089 443
- DE-U- 1 886 574
- DE-U- 8 625 990
- GB-A- 2 300 265
- PATENT ABSTRACTS OF JAPAN vol. 097, no. 010, 31.Oktober 1997 & JP 09 159491 A (YAMATAKE HONEYWELL CO LTD), 20.Juni 1997,

## Beschreibung

Die Erfindung betrifft ein elektronisches Gerät für den Einsatz in explosionsgefährdeten Bereichen.

In der industriellen Meßtechnik werden elektronische Geräte, insb. Meßgeräte, regelmäßig an Orten eingesetzt, an denen die Gefahr einer Explosion besteht. Hier seien als Beispiel Mehlsilos, Tankstellen und Chemieanlagen, an denen explosive Gase auftreten können, genannt.

An Geräte, die in explosionsgefährdeten Bereichen einsetzbar sind, werden besondere Sicherheitsanforderungen gestellt. Diese haben das Ziel eine Funkenbildung, die ggf. eine Explosion auslösen könnte, zu vermeiden oder zu verhindern, daß ein im Inneren eines abgeschlossenen Raumes entstehender Funke Auswirkungen auf die Umgebung hat. Dieses Ziel ist auf verschiedene Arten, die in entsprechenden Europäischen Normen als Zündschutzarten bezeichnet sind, erreichbar.

So ist z.B. gemäß der Europäischen Norm EN 50 020 aus dem Jahr 1994 Explosionsschutz gegeben, wenn Geräte gemäß der darin definierten Schutzklasse mit dem Namen 'Eigensicherheit' (Ex-i) ausgebildet sind. Gemäß dieser Schutzklasse haben die Werte für die elektrischen Größen Strom, Spannung und Leistung in einem Gerät zu jeder Zeit jeweils unterhalb eines vorgegebenen Grenzwertes zu liegen. Die drei Grenzwerte sind so gewählt, daß im Fehlerfall, z.B. durch einen Kurzschluß, die maximal entstehende Wärme nicht ausreicht, um einen Zündfunken zu erzeugen. Der Strom wird z.B. durch Widerstände, die Spannung z.B. durch Zener-Dioden und die Leistung durch entsprechende Kombination von strom- und spannungsbegrenzenden Bauteilen unter den vorgegebenen Grenzwerten gehalten.

In der Europäischen Norm EN 50 019 aus dem Jahr 1994 ist eine weitere Schutzklasse mit dem Namen 'Erhöhte Sicherheit' (Ex-e) angegeben. Bei Geräten, die gemäß dieser Schutzklasse ausgebildet sind, wird der Explosionsschutz dadurch erzielt, daß die räumlichen Abstände zwischen zwei verschiedenen elektrischen Potentialen so groß sind, daß eine Funkenbildung auch im Fehlerfall aufgrund der Distanz nicht auftreten kann. Dies kann jedoch unter Umständen dazu führen, daß Schaltungsanordnungen sehr große Abmessungen aufweisen müssen, um diesen Anforderungen zu genügen.

Eine weitere unter der Bezeichnung 'Druckfeste Kapselung' (Ex-d) geführte Schutzklasse ist in der Europäischen Norm EN 50 018 aus dem Jahr 1994 beschrieben. Geräte die gemäß dieser Schutzklasse ausgebildet sind, weisen ein druckfestes Gehäuse auf, durch das sichergestellt ist, daß eine im Inneren des Gehäuses auftretende Explosion nicht in den Außenraum übertragen werden kann. Druckfeste Gehäuse sind, damit sie eine ausreichende mechanische Festigkeit aufweisen, dickwandig und damit schwer und teuer.

In den USA, in Kanada, in Japan und anderen Ländern gibt es mit diesen Europäischen Normen vergleichbare Standards.

Ein Gerät ist in der Regel an eine elektrische Energieversorgung anzuschließen und/oder es sind Mittel zur Übertragung von Signalen vorzusehen. In vielen Fällen sind hierzu standardmäßig Leitungen vorgesehen, die gemäß der Schutzklasse Ex-d oder Ex-e bis zum Meßgerät verlegt sind. Z.B. werden, wenn am Einsatzort Explosionsgefahr besteht und verschiedene Meßgeräte vorzusehen sind, von denen einzelne so viel Leistung benötigen, daß sie nicht von einer eigensicheren Versorgung gespeist werden können, häufig für alle Geräte Leitungen gemäß der Schutzklasse Ex-d oder Ex-e vorgesehen. Auch gibt es Einsatzorte an denen eine eigensichere Versorgung aus anderen Gründen nicht zur Verfügung steht.

Ein Meßgerät gemäß der Schutzklasse Ex-d auszubilden, erfordert ein geschlossenes druckfestes und damit schweres und teures Gehäuse. Ein Meßgerät gemäß der Schutzklasse Ex-e auszubilden, erfordert die Einhaltung der oben beschriebenen Mindestabständen, was zu großen Abmessungen der einzelnen Bauteile führen kann.

Es ist eine Aufgabe der Erfindung, ein Gerät zum Einsatz in explosionsgefährdeten Bereichen anzugeben, das diese Nachteile nicht aufweist, kostengünstig herstellbar ist und zusätzlich ein hohes Maß an Flexibilität bietet.

Hierzu besteht die Erfindung in einem elektronischen Gerät für den Einsatz in explosionsgefährdeten Bereichen mit einem Gehäuse
- mit einem Anschlußraum,
   -- der gemäß der Schutzklasse Ex-d oder Ex-e ausgebildet ist,
   -- in dem ein Anschlußelement angeordnet ist,
      --- an das elektrische Leitungen anschließbar sind, und
   -- in dem eine Schaltung zur Begrenzung eines Stromes, einer Spannung und einer Leistung,
      --- die dem Gerät im Betrieb über die Leitungen zugeführt werden, angeordnet ist,
      --- wobei die Begrenzung gemäß den Anforderungen der Schutzklasse Ex-i erfolgt, und
- mit einem Elektronikraum,
   -- in dem eine gemäß der Schutzklasse Ex-i ausgebildete Elektronik angeordnet ist und
   -- der geöffnet werden kann,
- bei welchem Gehäuse der Anschlußraum und der Elektronikraum voneinander getrennt sind und
- eine druckfeste elektrische Durchführung vorgesehen ist,
   -- durch die mindestens eine Ausgangsleitung der Schaltung vom Anschlußraum in den Elektroniktraum geführt ist, wo sie im Betrieb an die Elektronik angeschlossen ist.

Gemäß einer Weiterbildung der Erfindung ist im Elektronikraum Platz zur Aufnahme eines Anzeige- und/oder Bedienelements vorgesehen ist.

Gemäß einer Ausgestaltung ist das Anzeige- und/oder Bedienelement bei geöffnetem Elektronikraum entnehmbar.

Gemaß einer Ausgestaltung ist die Elektronik als ein auswechselbares Einsteckmodul ausgebildet.

Gemäß einer weiteren Ausgestaltung ist das Anzeige- und/oder Bedienelement mittels einer lösbaren mechanischen Steckverbindung auf dem Einsteckmodul montierbar.

Gemäß einer Ausgestaltung ist das Anzeige- und/oder Bedienelement über eine Leitung mit der Elektronik verbunden und im Elektronikraum ist eine Vorrichtung zur Aufnahme der Leitung vorgesehen.

Gemäß einer weiteren Ausgestaltung ist der Elektronikraum durch einen ein Fenster aufweisenden Deckel verschließbar und das Anzeige- und/oder Bedienelement ist bei geschlossenem Deckel durch das Fenster hindurch von außen sichtbar.

Ein Vorteil der Erfindung besteht darin, daß das Gehäuse im Bereich des Elektronikraums im Vergleich zu einem gemäß der Schutzklasse Ex-d ausgebildeten Raum sehr dünne Wände aufweisen kann. Es ist damit leichter und kostengünstiger.

Aufgrund der eigensicheren Ausbildung der Elektronik weist diese geringere Abmessungen auf als entsprechende gemäß der Schutzklasse Ex-e ausgebildete Elektronik.

Der durch die Schutzklasse Ex-e bedingte erhöhte Platzbedarf bzw. die durch die Schutzklasse Ex-d bedingte erforderliche Druckfestigkeit beschränkt sich auschließlich auf den Anschlußraum. Alle nachfolgenden Bestandteile weisen geringere Abmessungen auf und die zugehörigen Gehäuseabschnitte sind dünnwandiger und damit leichter und kostengünstiger.

Ein weiterer Vorteil besteht darin, daß der Elektronikraum im Betrieb geöffnet werden kann, ohne daß eine Explosion zu befürchten ist. Dadurch wird die Flexibilität im Bezug auf die Einsatzmöglichkeiten und die Bedienbarkeit des Geräts deutlich erhöht. Unter Flexibilität wird hier z.B. die Möglichkeit verstanden am Einsatzort Zugang zur Elektronik zu haben, ohne daß besondere Vorkehrungen, z.B. das Abschalten einer Anlage und/oder Teilen davon, notwendig sind. Eine defekte Elektronik kann ausgestauscht werden und es eine Bedienung vor Ort ist auf einfache Weise, z.B. durch Tasten, realisierbar.

Die Erfindung und weitere Vorteile werden nun anhand der Figuren der Zeichnung, in denen ein Ausführungsbeispiel eines Geräts für den Einsatz in explosionsgefährdeten Bereichen dargestellt ist, näher erläutert; gleiche Teile sind in den Figuren mit gleichen Bezugszeichen versehen.
- Fig. 1: zeigt eine Explosionsdarstellung eines Meßgeräts;
- Fig. 2: zeigt eine Ansicht des Gehäuses von Fig. 1 und
- Fig. 3: zeigt eine weitere Ansicht des Gehäuses von Fig. 1.

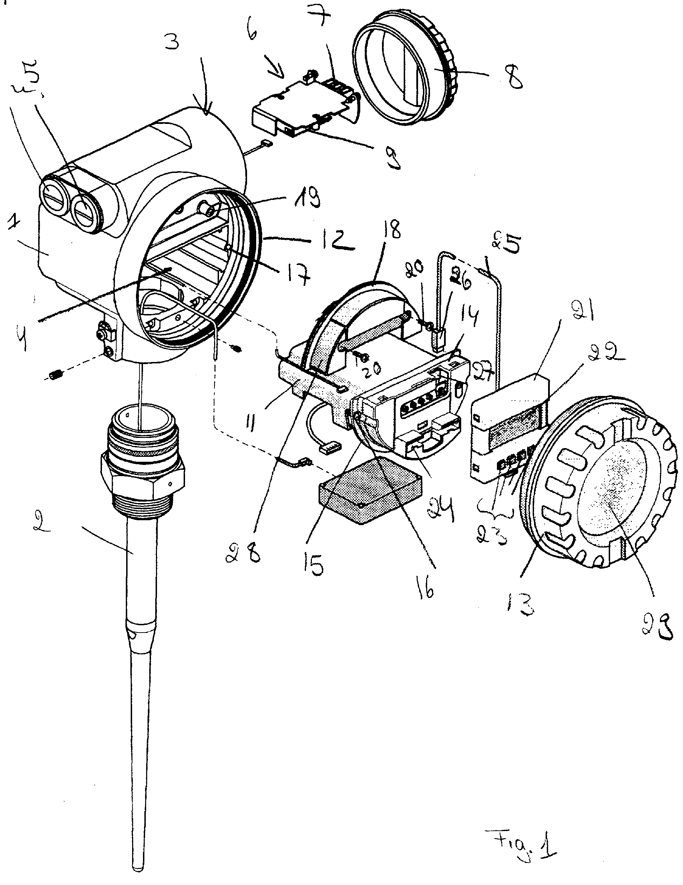

Fig. 1 zeigt eine Explosionsdarstellung eines Geräts für den Einsatz in explosionsgefährdeten Bereichen. In dem Ausführungsbeispiel ist das Gerät ein Meßgerät mit einem Gehäuse 1 und einer Meßeinheit 2. Die Meßeinheit 2 ist hier eine Antenne, mittels der Mikrowellen gesendet und/oder empfangen werden. Mikrowellen werden z.B. zur Füllstandsmessung eingesetzt. Dabei wird das Gerät oberhalb des zu messenden Füllstands angeordnet, die Laufzeit der Mikrowellen von der Antenne zur Füllgutoberfläche und zurück ermittelt und daraus der Füllstand bestimmt. Die Erfindung bezieht sich gleichermaßen auch auf andere Geräte, insb. auf andere Meßgeräte, wie z.B. auf anderen Meßprinzipien basierende Füllstandsmeßgeräte, Druck-, Differenzdruck- oder Durchflußmeßgeräte, insb. Wirbeldurchflußmesser.

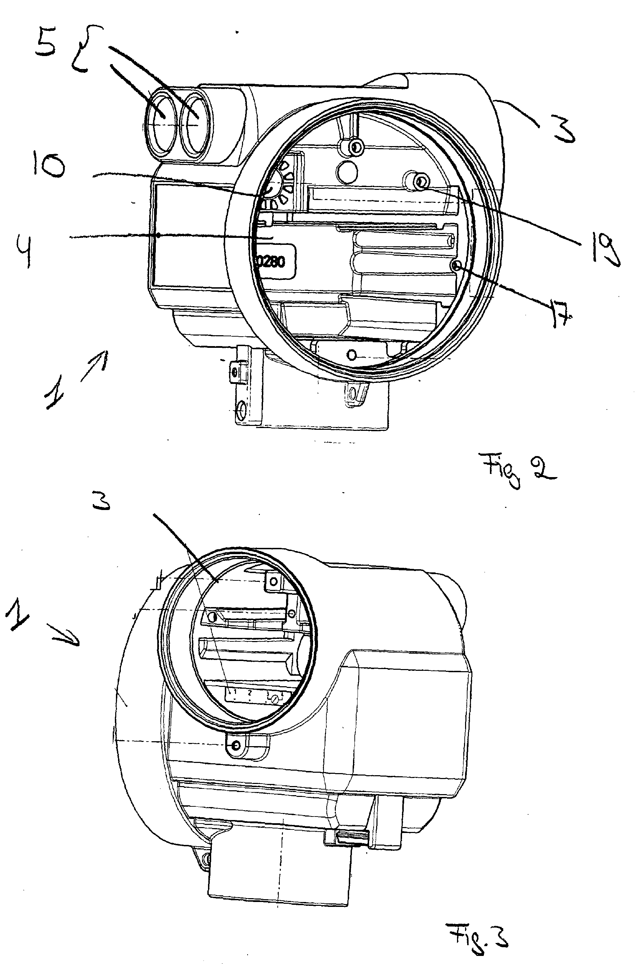

Das Gehäuse 1 weist zwei voneinander vollständig getrennte Bereiche auf, einen Anschlußraum 3 und einen Elektronikraum 4. Fig. 2 zeigt eine Ansicht des Gehäuses 1, bei der der Elektronikraum 4 einsehbar ist und Fig. 3 zeigt eine weitere Ansicht desselben, bei der der Anschlußraum 3 einsehbar ist.

Der Anschlußraum 3 ist gemäß den Anforderungen der Schutzklasse Ex-d oder Ex-e ausgebildet. Im Anschlußraum 3 erfolgt der elektrische Anschluß des Geräts. Hierzu sind zwei Leitungseinführungen 5 vorgesehen, durch die hindurch gemäß der Schutzklasse Ex-e oder Ex-d bis zum Gerät verlegte Leitungen in das Gerät einzuführen sind. Bei einem Meßgerät sind üblicherweise entweder zwei Versorgungsleitungen und zwei Signalleitungen oder aber zwei Leitungen über die sowohl die Versorgung des Geräts als auch eine Signalübertragung erfolgt vorzusehen. In dem Anschlußraum 3 ist ein Anschlußelement 6 angeordnet, an das die Leitungen elektrisch anschließbar sind. Dies ist z.B. wie in Fig. 1 schematisch dargestellt ein Klemmenblock 7. Bei einem gemäß der Schutzklasse Ex-e ausgebildeten Anschlußraum 3 ist der Klemmenblock 7 entsprechend den Vorschriften für die erhöhte Sicherheit Ex-e auszubilden, d.h. es sind insb. ausreichend große Abstände zwischen den einzelnen Klemmen vorzusehen. Der Anschlußraum 3 weist auf einer den Leitungseinführungen 5 gegenüberliegenden Seite eine Öffnung auf, die durch einen Deckel 8 verschließbar ist. Das Anschlußelement 6 ist als Einschubelement ausgebildet, das aus dem Anschlußraum 3 herausnehmbar ist. Bei der Montage werden zunächst die Leitungen durch die Leitungseinführungen 5 und den Anschlußraum 3 hindurch geführt und am Klemmenblock 7 angeschlossen. Anschließend ist der Anschlußraum 3 mit dem Deckel 8 zu verschließen. Ist der Anschlußraum 3 gemäß der Schutzklasse Ex-d ausgebildet, so weist der Deckel 7 vorzugsweise ein Gewinde auf, durch das sowohl Druckdichtheit als auch Flammendurchschlagsicherheit gemäß der Schutzklasse Ex-d gewährleistet ist.

Da der Anschlußraum 3 gemäß der Schutzklasse Ex-d oder Ex-e ausgebildet ist, darf der Anschlußraum 3 nur dann geöffnet werden, wenn die Leitungen spannungslos geschaltet sind. Im Betrieb ist der Anschlußraum 3 immer verschlossen.

Auf dem Anschlußelement 6 ist eine Schaltung 9 zur Begrenzung von dem Gerät über die Leitungen zugeführtem Strom, zugeführter Spannung und zugeführter Leistung gemäß der Schutzklasse Ex-i angeordnet. Derartige Schaltungen sind z.B. in der älteren europäischen Patentanmeldung mit dem Aktenzeichen 97 81 0349.7 vom 4. Juni 1997 beschrieben. Weitere Schaltungen dieser Art sind z.B. in der DE-C 36 22 268 und in der US-A 4,412,265 beschrieben.

Wie bereits beschrieben sind der Anschlußraum 3 und der Elektronikraum 4 vollständig voneinander getrennt. Zwischen den beiden Räumen ist eine druckfeste elektrische Durchführung 10 vorgesehen. Die Durchführung 10 ist in Fig. 2 schematisch eingezeichnet. Druckfeste Durchführungen, die den Anforderungen der Schutzklasse Ex-d genügen sind als Handelsware erhältlich.

Im Elektronikraum 4 ist eine gemäß der Schutzklasse Ex-i ausgebildete Elektronik 11 angeordnet. Durch die Durchführung 10 sind Ausgangsleitungen der Schaltung 9 vom Anschlußraum 3 in den Elektroniktraum 4 geführt, wo sie im Betrieb an die Elektronik 11 angeschlossen sind.

Die Elektronik 11 ist z.B. eine Meßgerätelektronik. Bei dem gezeigten Ausführungsbeispiel umfaßt sie z.B. ein Mikrowellenmodul zum Senden und/oder Empfangen von Mikrowellen, das an die Antenne angeschlossen ist, und eine Auswerteeinheit, die aus den Empfangssignalen einen Füllstand ermittelt und ein Ausgangssignal zur Verfügung stelllt, welches dem Füllstand entspricht.

Die elektrischen Verbindungen zwischen der Schaltung 9 und der Durchführung 10 sowie zwischen der Durchführung 10 und der Elektronik 11 sind vorzugsweise lösbare Steckverbindungen.

Da die Elektronik gemäß der Schutzklasse Ex-i ausgebildet ist und der Elektronikraum 4 und der Anschlußraum 3 voneinander getrennte Räume sind, kann der Elektronikraum 4 im Betrieb in einem explosionsgefährdeten Bereich geöffnet werden, ohne daß dadurch eine Explosion ausgelöst werden kann. Der Elektronikraum 4 weist eine kreisförmige Öffnung 12 auf die durch einen in die Öffnung 12 einschraubbaren Deckel 13 verschließbar ist.

Die Elektronik 11 ist vorzugsweise als ein auswechselbares Einsteckmodul ausgebildet. Wie aus Fig. 1 ersichtlich ist die Elektronik 11 zu diesem Zweck mit einem Modulgehäuse versehen, dessen Außengeometrie in groben Zügen der Innengeometrie des Elektronikraums 4 nachempfunden ist. Das Modulgehäuse ist mit einem Frontelement 14 versehen, das dem Deckel 13 zugewandt angeordnet ist. An dem Frontelement 14 ist eine umlaufende Schulter 15 mit Löchern für Schrauben 16 vorgesehen. Die Schrauben 16 sind zur weiteren Befestigung des Modulgehäuses im Elektronikraum 4 durch die Löcher in gegenüberliegende im Elektronikraum 4 angeordnete Gewindebohrungen 17 einzuschrauben.

Zusätzlich ist in dem Elektronikraum 4 eine Blende 18 vorgesehen. Die Blende 18 ist im wesentlichen halbkreisförmig und deckt im montierten Zustand einen Wandbereich des Elektronikraums 4 ab, hinter dem sich der Anschlußraum 3 befindet. In dem Wandbereich sind Gewindebohrungen 19 vorgesehen und die Blende 18 ist an dem Wandbereich mit in die Gewindebohrungen 19 eingeschraubten Schrauben 20 befestigt.

Im Elektronikraum 4 ist Platz zur Aufnahme eines Anzeige- und/oder Bedienelements 21 vorgesehen. Ein Anzeigeelement dient z.B. dazu Meßwerte vor Ort anzuzeigen. Mit einem Bedienlement kann ein Gerät vor Ort entsprechend dessen Funktion eingestellt werden. Das dargestellte Element weist sowohl eine Anzeige 22 als auch Tasten 23 zur Bedienung des Geräts auf.

Das Anzeige- und/oder Bedienelement 21 ist mittels einer lösbaren mechanischen Steckverbindung auf dem Einsteckmodul montierbar. Hierzu weist das Frontelement 14 auf dessen deckel-zugewandter Seite eine Rastvorrichtung 24 auf und auf der Rückseite des Anzeige- und/oder Bedienelement 21 ist ein entsprechendes, in Fig. 1 nicht dargestelltes Gegenstück vorsehen, das beider Montage in die Rastvorrichtung 24 eingreift.

Das Anzeige- und/oder Bedienelement 21 ist entweder über eine drahtlose Verbindung, z.B. über Infrarotsender und -empfänger, oder, wie in Fig. 1 dargestellt, über eine Leitung 25 mit der Elektronik 11 verbunden. Diese Leitung 25 weist an deren Ende einen Stecker 26 auf der in einen entsprechenden an dem Frontelement 14 angeordneten Anschluß 27 einsteckbar ist.

Zur Aufnahme der Leitung 25 ist im Elektronikraum 4 eine Vorrichtung vorgesehen. Diese umfaßt eine auf der Blende 18 angeordnete Abdeckung 28. Die Abdeckung 28 weist einen Schlitz auf durch den die Leitung 25 in einen durch die Abdeckung 28 und die Blende 18 begrenzten Hohlraum einbringbar ist.

Das Anzeige- und/oder Bedienelement 21 bei geöffnetem Elektronikraum 4 entnehmbar. Dies bietet den Vorteil, daß die Anzeige und/oder Bedienung an einem von dem Elektronikraum 4 entfernten Ort stattfinden kann. Dies ist besonders dannn vorteilhaft, wenn das Gerät an einem schwer zugänglichen Ort angeordnet ist oder der Platz in der unmittelbaren Nähe des Geräts sehr begrenzt ist.

Der Deckel 13 mit dem der Elektronikraum 4 verschließbar ist, weist vorzugsweise ein Fenster 29 auf. Bei geschlossenem Deckel 13 ist das Anzeige- und/oder Bedienelement 21 das Fenster 29 hindurch von außen sichtbar.

## Patentansprüche

1. Elektronisches Gerät für den Einsatz in explosionsgefährdeten Bereichen mit einem Gehäuse (1)
- mit einem Anschlußraum (3),
- der gemäß der Schutzklasse Ex-d nach der Europäischen Norm EN 50 018 aus dem Jahr 1994 oder Ex-e nach der Europäischen Norm EN 50 019 aus dem Jahr 1994 ausgebildet ist,
-- in dem ein Anschlußelement (6) angeordnet ist,
--- an das elektrische Leitungen anschließbar sind, und
-- in dem eine Schaltung (9) zur Begrenzung eines Stromes, einer Spannung und einer Leistung,
-- die dem Gerät im Betrieb über die Leitungen zugeführt werden, angeordnet ist,
--- wobei die Begrenzung gemäß den Anforderungen der Schutzklasse Ex-i nach der Europäischen Norm EN 50 020 aus dem Jahr 1994 erfolgt, und
- mit einem Elektronikraum (4),
-- in dem eine gemäß der Schutzklasse Ex-i ausgebildete Elektronik (11) angeordnet ist und
-- der geöffnet werden kann,
- bei welchem Gehäuse (1) der Anschlußraum (3) und der Elektronikraum (4) voneinander getrennt sind und
- eine druckfeste elektrische Durchführung (10) vorgesehen ist, durch die mindestens eine Ausgangsleitung der Schaltung (9) vom Anschlußraum (3) in den Elektroniktraum (4) geführt ist, wo sie im Betrieb an die Elektronik (11) angeschlossen ist.

2. Gerät nach Anspruch 1, bei dem im Elektronikraum (4) Platz zur Aufnahme eines Anzeige- und/oder Bedienelements (21) vorgesehen ist.

3. Gerät nach Anspruch 2, bei dem das Anzeige- und/oder Bedienelement (21) bei geöffnetem Elektronikraum (4) entnehmbar ist.

4. Gerät nach Anspruch 1, bei dem die Elektronik (11) als ein auswechselbares Einsteckmodul ausgebildet ist.

5. Gerät nach Anspruch 4 und nach Anspruch 2 oder 3, bei dem das Anzeige- und/oder Bedienelement (21) mittels einer lösbaren mechanischen Steckverbindung auf dem Einsteckmodul montierbar ist.

6. Gerät nach Anspruch 2, bei dem das Anzeige- und/oder Bedienelement (21) über eine Leitung (25) mit der Elektronik (11) verbunden ist und im Elektronikraum (4) eine Vorrichtung zur Aufnahme der Leitung (25) vorgesehen ist.

7. Gerät nach Anspruch 2, bei dem der Elektronikraum (4) durch einen ein Fenster (28) aufweisenden Deckel (13) verschließbar ist und bei dem das Anzeige- und/oder Bedienelement (21) bei geschlossenem Deckel (28) durch das Fenster (28) hindurch von außen sichtbar ist.

8. Gerät nach einem der vorherigen Ansprüche, mit einer Meßeinheit (2).

## Claims

1. Electronic device for use in hazardous areas with a housing (1)
- with a connection compartment (3)
-- which is designed in accordance with the Ex d protection class as per the European Standard EN 50 018 of 1994, or the Ex e protection class as per the European Standard EN 50 019 of 1994.
-- in which a connection element (6) is arranged
--- to which electrical cables can be connected and
-- in which a circuit (9) is arranged to limit a current, a voltage and a power
--- which are fed to the device via the cables during operation
--- where the limitation is in accordance with the requirements of the Ex i protection class as per the European Standard EN 50 020 of 1994 and
- with an electronics compartment (4)
-- in which electronics (11), designed in accordance with the Ex i protection class, are arranged and
-- which can be opened
- and in said housing (1) the connection compartment (3) and the electronics compartment (4) are separated from one another and
- a pressure-tight electrical feedthrough (10) is provided through which at least one output line of the circuit (9) is routed from the connection compartment (3) into the electronics compartment (4) where it is connected to the electronics (11) during operation.

2. Device as per Claim 1, where space for accommodating a display and/or operating element (21) is provided in the electronics compartment (4).

3. Device as per Claim 2, where the display and/or operating element (21) can be removed when the electronics compartment (4) is open.

4. Device as per Claim 1, where the electronics (11) are designed as a replaceable plug-in module.

5. Device as per Claim 4 and as per Claim 2 or 3, where the display and/or operating element (21) can be mounted on the plug-in module via a non-permanent mechanical plug-in connection.

6. Device as per Claim 2, where the display and/or operating element (21) is connected to the electronics (11) via a cable (25) and a unit for accommodating the cable (25) is provided in the electronics compartment (4).

7. Device as per Claim 2, where the electronics compartment (4) can be closed by a cover (13) with a window (28), and where the display and/or operating element (21) is visible from the outside through the window (28) when the cover (13) is closed.

8. Device as per one of the previous claims with a measuring unit (2).

## Revendications

1. Appareil électronique destiné à une utilisation au sein de zones explosibles avec un boîtier (1)
- avec un compartiment de raccordement (3),
-- qui est conçu conformément à la classe de protection Ex-d selon la norme européenne EN 50 018 de l'année 1994 ou Ex-e selon la norme européenne EN 50 019 de l'année 1994,
-- dans lequel est disposé un élément de raccordement (6)
--- auquel il est possible de raccorder des conducteurs électriques, et
-- dans lequel est disposé un circuit (9) destiné à la limitation d'un courant, d'une tension et d'une puissance,
--- qui sont acheminés à l'appareil en fonctionnement par l'intermédiaire des conducteurs,
--- la limitation s'opérant conformément aux exigences de la classe de protection Ex-i selon la norme européenne EN 50 020 de l'année 1994, et
- avec un compartiment électronique (4),
-- dans lequel est disposée une électronique (11) conçue conformément à la classe de protection Ex-i et
-- qui peut être ouvert,
- boîtier (1) pour lequel le compartiment de raccordement (3) et le compartiment électronique (4) sont séparés l'un par rapport à l'autre et
- pour lequel est prévu un passage électrique (10) à travers lequel au minimum un câble de sortie du circuit (9) est acheminé depuis le compartiment de raccordement (3) dans le compartiment électronique (4), où il est raccordé, en fonctionnement, à l'électronique (11).

2. Appareil selon la revendication 1, pour lequel il est prévu, dans le compartiment électronique (4), de la place pour le logement d'un élément de commande et/ou d'affichage (21).

3. Appareil selon la revendication 2, pour lequel l'élément de commande et/ou d'affichage (21) peut être enlevé lorsque le compartiment électronique (4) est ouvert.

4. Appareil selon la revendication 1, pour lequel l'électronique (11) est conçue sous la forme d'un module enfichable interchangeable.

5. Appareil selon la revendication 4 et selon la revendication 2 ou 3, pour lequel l'élément de commande et/ou d'affichage (21) peut être monté sur le module enfichable au moyen d'une connexion mécanique amovible.

6. Appareil selon la revendication 2, pour lequel l'élément de commande et/ou d'affichage (21) est relié avec l'électronique (11) par l'intermédiaire d'un câble (25) et pour lequel est prévu dans le compartiment électronique (4) un dispositif destiné au logement du câble (25).

7. Appareil selon la revendication 2, pour lequel le compartiment électronique (4) peut être fermé au moyen d'un couvercle présentant une fenêtre (28) et pour lequel l'élément de commande et/ou d'affichage (21) est visible de l'extérieur, à travers la fenêtre (28), lorsque le couvercle (13) est monté.

8. Appareil selon l'une des revendications précédentes, avec une unité de mesure (2).
